# EUROPÄISCHE PATENTSCHRIFT

(11) **EP 1 436 842 B1**
(45) Veröffentlichungstag und Bekanntmachung des Hinweises auf die Patenterteilung: **01.06.2005**
(21) Anmeldenummer: 02774707.0
(22) Anmeldetag: 11.10.2002
(51) Int. Cl.: H01L 29/732, H01L 21/331

(54) **BIPOLAR-TRANSISTOR UND VERFAHREN ZUM HERSTELLEN DESSELBEN**
BIPOLAR TRANSISTOR AND METHOD FOR PRODUCING THE SAME
TRANSISTOR BIPOLAIRE ET PROCEDE DE FABRICATION ASSOCIE

(30) Priorität: 04.12.2001 DE 10159414
(43) Veröffentlichungstag der Anmeldung: 14.07.2004
(73) Patentinhaber: Infineon Technologies AG, 81669 München (DE)
(72) Erfinder: LACHNER, Rudolf, 85051 Ingolstadt (DE)
(74) Vertreter: Stöckeler, Ferdinand, Dipl.-Ing.
(86) Internationale Anmeldenummer: PCT/EP2002/011427
(87) Internationale Veröffentlichungsnummer: WO 2003/049192

(56) Entgegenhaltungen:
- EP-A- 0 287 318
- EP-A- 1 152 462
- US-A- 3 600 651
- US-A- 5 599 723
- US-A- 5 962 879
- KLEIN W ET AL: "75 GHZ BIPOLAR PRODUCTION TECHNOLOGY FOR THE 21ST CENTURY" PROCEEDINGS OF THE EUROPEAN SOLID STATE DEVICE RESEARCH CONFERENCE (ESSDERC), EDITION FRONTIERES, GIL-SUR-YVETTE, FR, 13. September 1999 (1999-09-13), Seiten 88-94, XP008012699 in der Anmeldung erwähnt

## Beschreibung

Die vorliegende Erfindung bezieht sich auf Bipolar-Transistoren und insbesondere auf vertikale Bipolar-Transistoren in SOI-Technologie sowie auf die Herstellung derselben.

Bei der Anwendung von Bipolar-Transistoren im Analogbereich werden hohe Anforderungen an die Rauschfreiheit, die Hochgeschwindigkeits- bzw. Hochfrequenzfähigkeit und den Leistungsverbrauch von Bipolar-Transistoren gestellt. Zur Kostenreduzierung besteht zusätzlich der Wunsch, Bipolar-Transistoren mittels Standardverfahren, wie z.B. in CMOS-(complementary metal-oxide semiconductor) Technologie, herstellen zu können.

In H. Nii, usw., "A 67 GHz fmax Lateral Bipolar Transistor with Co-silicid Base Electrode Structure on Thin Film SOI for RF Analog Applications", in Maes, H. usw., ESSDERC '99, Proceedings of the 29^{th} European Solid-State Device Research Conference, Leuven '99, Seite 212-215, wird ein lateraler Bipolar-Transistor in SOI-Technologie beschrieben. Die Herstellung des Bipolar-Transistors geht von einem SOI-Substrat bestehend aus einer SOI- (silicon on insolator = Silizium auf Isolator) Schicht und einer BOX- (BOX = buried oxid = vergrabenes Oxid) Schicht aus. Zunächst werden N⁻-Kollektorionen in die SOI-Schicht implantiert. Danach wird eine Polysiliziumschicht auf der SOI-Schicht aufgebracht und mit BF₂ implantiert. Bis auf einen kleinen lateralen Bereich werden die polykristalline Schicht und das einkristalline Silizium der SOI-Schicht bis in die SOI-Schicht hinein geätzt. Durch geneigte B- und BF₂-Implantation und Implantationen von Emitter- und Kollektor-Ionen wird in der SOI-Schicht ein lateraler NPN-Bipolar-Transistor verwirklicht. An der Polysilizium-Schicht wird als Basisanschluß eine Co-Silizid-Basis-Elektrode gebildet.

In K. Washio, "A 0.2-µm 180-GHz-fₘₐₓ 6.7-ps-ECL SOI/HRS Self-Aligned SEG SiGe HPT/CMOS Technology for Microwave and High-Speed Digital Application", IEDM 2000, S. 741-744, wird ein CMOS-Heterostruktur-Bipolar-Transistor auf SOI-Basis beschrieben, bei dem eine Kollektorwanne in der SOI-Schicht gebildet wird, and bei dem der Basis-, Basisanschluß- und Emitterbereich durch Polysilizium-Aufbringung gebildet werden, so daß dieser Heterostruktur-Bipolar-Transistor einen Doppelpolysiliziumschichtenaufbau aufweist.

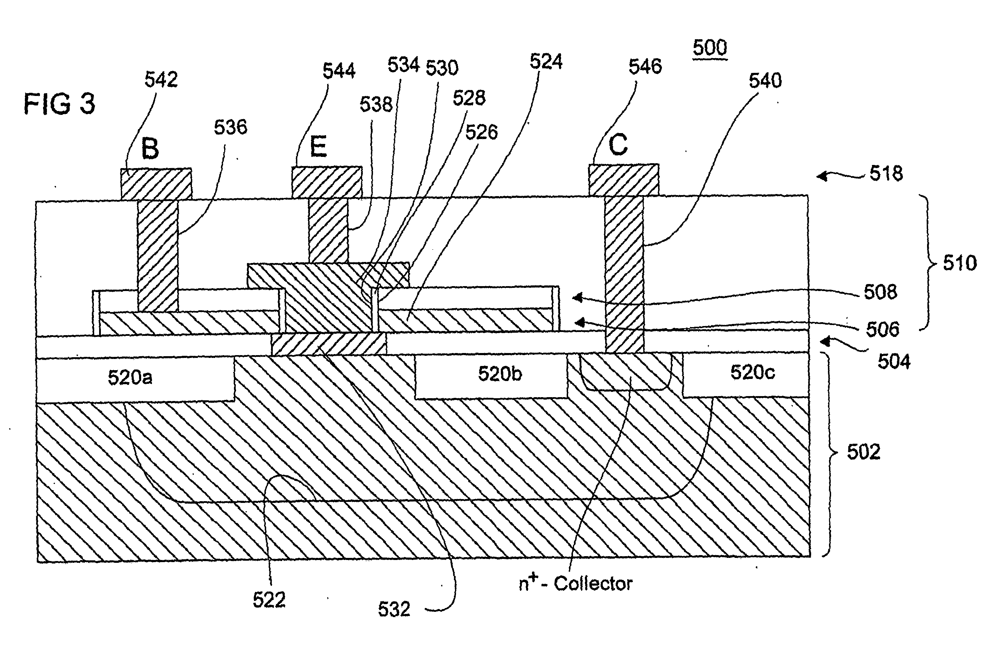

In W. Klein, usw., "75 GHz Bipolar Production-Technology for the 21^{st} Centory", in Maes, H. usw., ESSDERC '99, Proceedings of the 29^{th} European Solid-State Device Research Conference, Leuven '99, S. 88-94, wird ein Bipolar-Transistor beschrieben, dessen Aufbau demjenigen entspricht, der in Fig. 3 gezeigt ist. Der in Fig. 3 gezeigte Bipolar-Transistor 500 besteht aus einem p-Substrat 502, einer Oxid-Schicht 504, einer Polysilizium-Schicht 506, einer zweiten Oxidschicht 508, einer Isolationsschicht 510 und einer Metallschicht 518, die geeignet bearbeitet worden sind, um den Bipolar-Transistor 500 zu ergeben.

EP-A-0 287 318 offenbart einen Transistor mit einem Polysilizium-Basisanschluß.

Der in Fig. 3 gezeigte Bipolar-Transistor 500 benötigt zu seinem Aufbau folgende Herstellungsschritte. Zunächst werden durch ein Locos-Verfahren oder eine Grabenisolationstechnik (STI; STI = shallow Trench Isolation) Oxidstege 520a, 520b und 520c in dem p-Substrat 502 gebildet. Danach wird durch Hochenergieimplantation eine n-Kollektorwanne 522 in dem p-Substrat gebildet. Auf diese Struktur wird die Oxid-Schicht 504 aufgebracht. Auf die Schicht 504 wird wiederum die Polysilizium-Schicht 506 aufgebracht und einer p⁺-Dotierung unterzogen. Auf die Schicht 506 wird nachfolgend die zweite Oxidschicht 508 und eine weitere Schicht (in dem in Fig. 3 gezeigten Endzustand nicht gezeigt, da dieselbe vor der Fertigstellung wieder entfernt wird) aufgebracht. Der Stapel aus den Schichten 508, 506 und 504 wird daraufhin geeignet strukturiert, um einen Basisanschluß 524 aus der Polysilizium-Schicht 506 und ein Loch 526 in dem Stapel aus Schichten 506, 508 und der Schicht aus Nitrid zu bilden. In dem Loch 526 wird durch ein geeignetes Verfahren ein Nitridseitenwandspacer erzeugt, der ein Emitterfenster 530 definiert. Durch das Emitterfenster 530 wird durch Naßätzen ein Basisbereich 532 gebildet, in welchem durch selektives epitaktisches Aufwachsen ein Epitaxiebasisbereich 532 gebildet wird. Nach einer Nitridentfernung, bei der die nicht gezeigte Nitridschicht entfernt wird, und einer nochmaligen Erzeugung eines Spacers 528 wird n-dotiertes polykristallines Silizium aufgebracht und strukturiert, um einen Emitterbereich 534 zu bilden. Durch Aufbringen der Isolationsschicht 510, Vorsehen von Kontaktierungen 536, 538 und 540 zur Kontaktierung des Basisanschlusses 524, des Emitterbereiches 534 bzw. der n-Kollektorwanne 522 und durch Vorsehen der Metallkontakte 542, 544 und 546 in der Metallschicht 518 ist die Herstellung des Bipolar-Transistors 500 abgeschlossen.

Nachteilig an dem in Fig. 3 gezeigten Bipolar-Transistor ist seine relativ aufwendige Herstellung. Insbesondere müssen auf dem Substrat 502 zur Herstellung des Bipolartransistors fünf Schichten aufgebracht werden, nämlich die Oxid-Schicht 504, die Polysilizium-Schicht 506, die zweite Oxidschicht 508, die Nitridschicht und das polykristalline Material des Emitteranschlusses 534.

Die Aufgabe der vorliegenden Erfindung besteht darin, einen Bipolar-Transistor und ein Verfahren zum Herstellen desselben zu schaffen, der bzw. das unaufwendiger ist.

Diese Aufgabe wird durch einen Bipolar-Transistor gemäß Anspruch 13 und ein Verfahren gemäß Anspruch 1 gelöst.

Der vorliegenden Erfindung liegt die Erkenntnis zugrunde, daß die Herstellung eines Bipolar-Transistors deutlich unaufwendiger gestaltet werden kann, wenn zu seiner Herstellung eine Schichtfolge bestehend aus einem Substrat, einer BOX-Schicht und einer SOI-Schicht verwendet wird, und dabei der Basisbereich in der BOX-Schicht erzeugt wird, während der Kollektorbereich in dem Substrat gebildet wird. Hierdurch werden andernfalls notwendige Herstellungsprozeßschritte und insbesondere Schichtaufbringangs- bzw. Schichtabscheidungsprozesse für z.B. eine Polysilizium- oder Oxidschicht, eingespart.

Ein weiterer Vorteil der vorliegenden Erfindung besteht darin, daß die monokristalline ISO-Schicht über der BOX-Schicht als Basisanschlußschicht verwendet werden kann. Neben der Einsparung eines Prozeßschrittes der Abscheidung einer entsprechenden Polysilizium-Schicht, wie bei dem in Fig. 3 gezeigten herkömmlichen Bipolar-Transistor, ergibt sich aus der Tatsache, daß die Basisanschlußschicht aus monokristallinem Silizium gebildet ist, eine Realisierung wesentlich niedrigerer externer Basiswiderstände, was insbesondere für Low-Noise- (Niedrig-Rauschen-) Anwendungen wichtig ist.

Ein weiterer Vorteil der vorliegenden Erfindung besteht darin, daß sie die Integration eines vertikalen Bipolar-Transistors auf einem Dünn-SOI-Substrat ermöglicht. Insbesondere kann die Siliziumschicht bzw. die SOI-Schicht auf der BOX-Schicht sehr dünn sein, da sie lediglich als Basisanschlußschicht dienen muß, und gegebenenfalls nur noch zur Herstellung von Widerständen verwendet wird. Da die SOI-Schicht ausreichend dünn sein kann, können in dieselbe auch FD- (Fully Depleted = Vollständige-Verarmung-) und PD- (PD = Partially Depleted = Teilweise-Verarmung-) -CMOS-Transistoren integriert werden.

Ein weiterer Vorteil der vorliegenden Erfindung besteht darin, daß der erfindungsgemäße Bipolar-Transistor und das erfindungsgemäße Verfahren zur Herstellung desselben mit Standard-CMOS-Verfahren integrierbar bzw. verträglich sind. Insbesondere kann die vorliegende Erfindung mit Standard-SOI-Material verwendet werden, wie es für die Verwendung mit der CMOS-Technologie vorgesehen ist, wodurch sich effektiv eine BiCMOS-Technologie auf SOI-Basis ergibt.

Bevorzugte Ausführungsbeispiele der vorliegenden Erfindung werden nachfolgend Bezug nehmend auf die beiliegenden Zeichnungen näher erläutert. Es zeigen:
- Fig. 1: den Querschnitt eines Bipolar-Transistors gemäß einem Ausführungsbeispiel der vorliegenden Erfindung;
- Fig. 2: ein Flußdiagramm, das die Schritte zur Herstellung des Bipolar-Transistors von Fig. 1 gemäß einem Ausführungsbeispiel der vorliegenden Erfindung zeigt; und
- Fig. 3: eine Schnittansicht eines Bipolar-Transistors herkömmlicher Art.

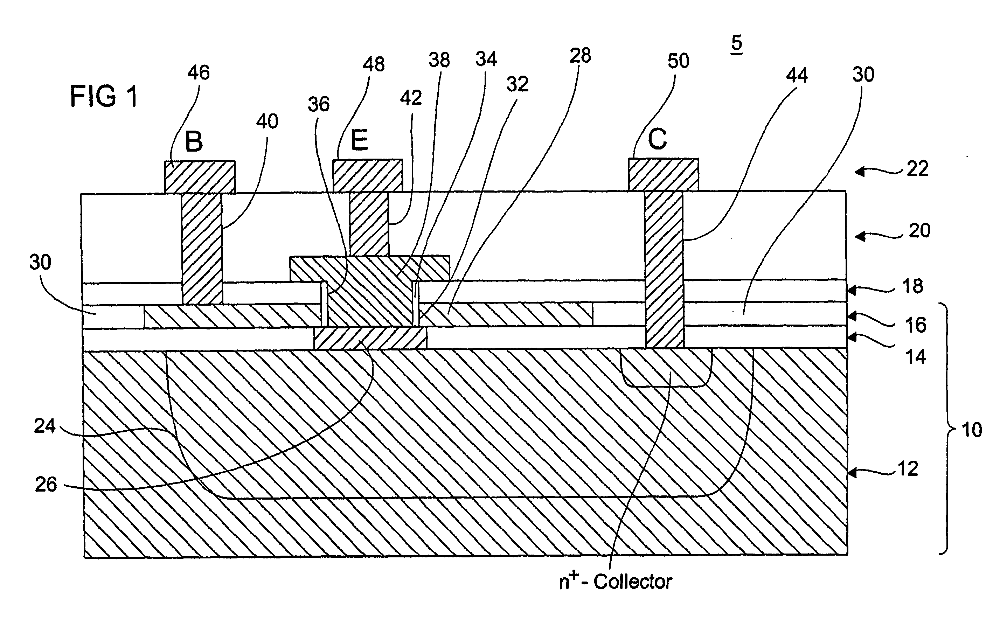

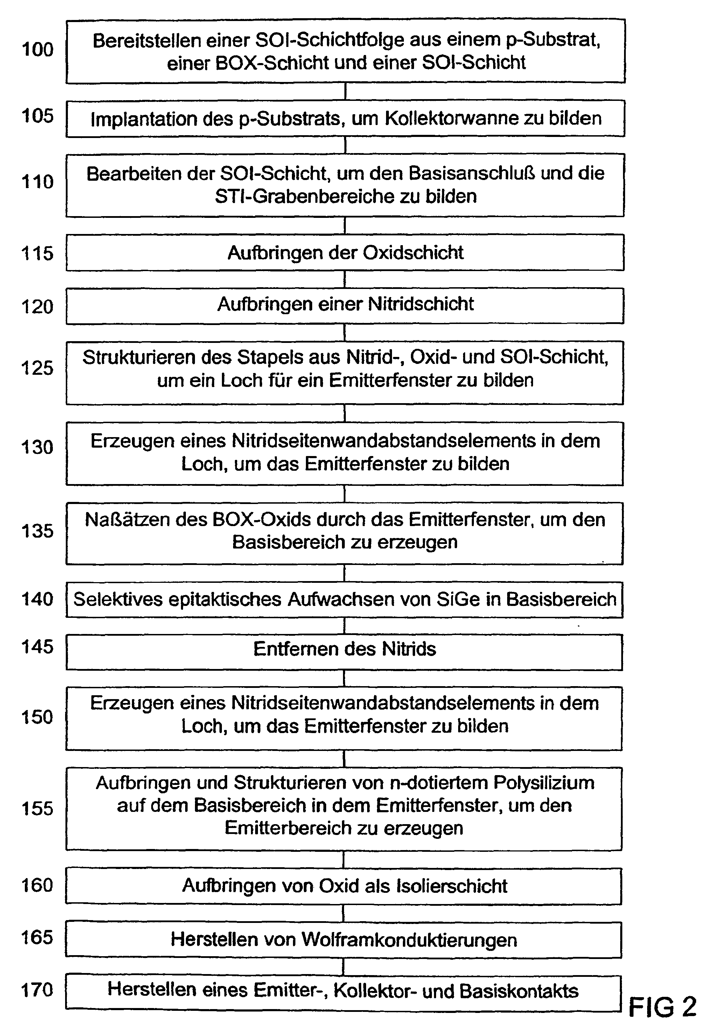

Gemäß Fig. 1 wird zunächst der Aufbau eines Bipolar-Transistors gemäß einem Ausführungsbeispiel der vorliegenden Erfindung beschrieben, während Bezug nehmend auf Fig. 2 die Herstellung desselben beschrieben wird.

Der Bipolar-Transistor von Fig. 1 ist ein vertikaler Bipolar-Transistor 5 mit epitaxialer Basis, der in SOI-Technik hergestellt ist. Der Bipolar-Transistor besteht im wesentlichen aus einer Schichtfolge 10, die ein p-Substrat 12, eine BOX-Schicht bzw. erste Oxidschicht 14 und eine SOI-Schicht 16 umfaßt, wobei die BOX-Schicht 14 zwischen der SOI-Schicht 16 und dem p-Substrat 12 angeordnet ist. Der Bipolar-Transistor 5 umfaßt ferner eine zweite Oxidschicht 18 auf der SOI-Schicht 16 und eine Oxidisolationsschicht 20 auf der zweiten Oxidschicht 18. Auf der Isolationsschicht 20 ist wiederum eine strukturierte Metallschicht 22 angeordnet.

Das p-Substrat dient als Transistorunterbau. In dem p-Substrat ist ein dotierter Bereich einer n-Kollektorwanne 24 gebildet. Darüber befindet sich in der BOX-Schicht ein epitaxiales Si- oder SiGe-Basisgebiet bzw. ein epitaxialer Si oder SiGe-Basisbereich 26. In der über der BOX-Schicht 14 angeordneten SOI-Schicht 16 ist ein Basisanschlußbereich 28 gebildet. Der Basisanschlußbereich 28 ist p-dotiert und besteht, da er ein Teil der SOI-Schicht 16 ist, aus monokristallinem Silizium. Der Basisanschlußbereich 28 ist ringförmig oder rahmenförmig gestaltet, wobei sich außerhalb desselben in der SOI-Schicht 16 ein STI-Grabenbereich 30 befindet. Im Inneren des Basisanschlußbereiches 28 befindet sich ein Öffnungsbereich 32, innerhalb dessen der Basisanschlußbereich 28 unterbrochen ist. Der Öffnungsbereich 32 erstreckt sich auch über die zweite Oxidschicht 18, so daß dieselbe über die laterale Ausdehnung des Öffnungsbereiches 32 hinweg ebenfalls unterbrochen ist. Die laterale Ausdehnung des Öffnungsbereiches 32 erstreckt sich lediglich über einen Teil der lateralen Ausdehnung des Basisbereiches 26, so daß sich ein weiterer Teil des Basisbereiches 26 zwischen den Basisanschlußbereich 28 und das p-Substrat 12 erstreckt, wodurch sich der Basisbereich 26 in Kontakt mit dem Basisanschlußbereich 28 befindet. Der Kontakt zwischen dem Basisbereich 26 und dem Basisanschlußbereich 28 ist zwischen einem Außenrandbereich einer Oberfläche des Basisbereiches 26 und einem Innenrandbereich einer angrenzenden Oberfläche des Basisanschlußbereiches 28 hergestellt. Der Öffnungsbereich 32 definiert eine Seitenwand, entlang der sich ein Spacer bzw. Abstandselement 34 erstreckt, das ein Emitterfenster 36 umgibt bzw. definiert. In dem Emitterfenster 36 ist ein Emitterbereich 38 gebildet, der den Basisbereich 26 kontaktiert, von dem Basisanschlußbereich 28 durch das Abstandelement 32 isoliert ist, sich teilweise über die zweite Oxidschicht 18 erstreckt und sowohl als Emitter als auch als Emitteranschluß dient. Von der oberen, der zweiten Oxidschicht 18 abgewandten Oberfläche der Isolationsschicht 20 erstrecken sich vertikal aus einer Wolframfüllung bestehende Kontaktierungen 40, 42 und 44 bis zu dem Basisanschlußbereich 28, dem Emitterbereich 38 bzw. der n-Kollektorwanne 24. Hierdurch verbinden die Kontaktierungen 40-44 den Basisanschlußbereich 28, den Emitterbereich 38 und die n-Kollektorwanne 24 mit einem in der Metallschicht 22 gebildeten Basiskontakt 46, Emitterkontakt 48 bzw. Kollektorkontakt 50.

Der Bipolar-Transistor 5 von Fig. 1 stellt einen vertikalen npn-Bipolar-Transistor dar, der sowohl auf einem SOI-Material integrierbar ist als auch eine epitaxiale Si- oder SiGe-Basis aufweist. Da der Basisanschlußbereich 28 aus dem monokristallinen Silizium der SOI-Schicht 16 der Schichtfolge 10 gebildet ist, ist der Bipolar-Transistor 5 aufgrund der Realisierung wesentlich niedrigerer externer Basiswiderstände sehr gut für Low-Noise-Anwendungen geeignet.

Da in der SOI-Schicht 16 lediglich der Basisanschlußbereich 28 gebildet ist, kann diese Schicht sehr dünn gebildet sein. Die Dicke der p-dotierten SOI-Schicht beträgt beispielsweise 150 nm, während die Dicke der BOX-Schicht 100 nm beträgt.

Zusätzlich ist der Bipolar-Transistor 5 mit der CMOS-Technologie verträglich. Deshalb läßt sich der Bipolar-Transistor 5 in CMOS-Schaltungen integrieren. Bei Integration des Bipolar-Transistors 5 in CMOS-Schaltungen können in die dünne SOI-Schicht 16 beispielsweise Widerstände und FD- bzw. PD-CMOS-Transistoren integriert sein. Der Source- und der Drain-Anschluß der CMOS-Transistoren sind hierbei in der epitaxialen SOI-Schicht gebildet. Hinsichtlich der Integration von FETs in dünnen SOI-Schichten in Standard-CMOS-Technologie wird ferner auf Shahidi, G., usw., "Mainstreaming of the SOI Tchnology", in Maes, H. usw., ESSDERC '99, Proceedings of the 29^{th} European Solid-State Device Research Conference, Leuven '99, S. 3 - 10, verwiesen, das hiermit unter Bezugnahme in die Beschreibung aufgenommen wird.

Im folgenden wird bezugnehmend auf Fig. 2 die Herstellung des Bipolar-Transistors von Fig. 1 gemäß einem Ausführungsbeispiel der vorliegenden Erfindung beschrieben, wobei ebenfalls auf Fig. 1 Bezug genommen wird.

Das Herstellungsverfahren beginnt bei Schritt 100 mit der Bereitstellung der SOI-Schichtfolge 10. Die Dicke der SOI-Schicht 16 beträgt beispielsweise 150 nm, während die Dicke der BOX-Schicht 14 100 nm beträgt Das monokristalline Silizium der SOI-Schicht 16 ist p⁺-dotiert, wobei es jedoch ferner möglich ist, daß die Dotierung erst später in einem folgenden Prozeßschritt erfolgt.

In einem Schritt 105 wird eine geeignete Implantation des p-Substrats 12 durchgeführt, um die Kollektorwanne 24 in dem p-Substrat 12 zu bilden. Die Implantation wird beispielsweise mittels Hochenergiephosphorimplantation durchgeführt. Die Implantation kann auch aus mehreren Schritten bestehen, um eine Struktur von Bereichen mit unterschiedlicher Dotierung in der Kollektorwanne 24 zu erzeugen. In dem Schritt 105 könnte beispielsweise auch die Dotierung der SOI-Schicht 16 vorgenommen werden.

In einem Schritt 110 wird die SOI-Schicht 16 einer STI-Bildung unterzogen, wodurch einerseits der Basisanschlußbereich 28 aus dem Material der SOI-Schicht 16 und der STI-Grabenbereich 30 aus einem Oxid gebildet wird. Der Schritt 110 kann beispielsweise durch Strukturieren der SOI-Schicht 116, um den Basisanschlußbereich 28 und einen Graben für den Grabenbereich 30 zu bilden, und ein TEOS-Verfahren (TEOS = Tetra-Ethyl-Ortho-Silicat = Tetraethylorthosilikat) zum Auffüllen des Grabens für den Grabenbereich 30 zur Bildung des STI-Grabenbereiches 30 aufweisen. Die Strukturierung des Basisanschlußbereiches 28 betrifft hierbei nur seine Außenabmessungen.

In einem Schritt 115 wird danach auf der SOI-Schicht 16 die zweite Oxidschicht 18 aufgebracht.

In einem Schritt 120 wird eine weitere Nitridschicht (nicht gezeigt in Fig. 1, da dieselbe vor Fertigstellung des Bipolar-Transistors 5 wieder entfernt wird) auf der zweiten Oxidschicht 18 aufgebracht.

In einem Schritt 125 wird der Stapel aus Nitridschicht, Oxidschicht 18 und SOI-Schicht 16 strukturiert, um den Öffnungsbereich 32 bzw. ein Loch für das Emitterfenster 36 zu bilden. Die Strukturierung in Schritt 125 kann beispielsweise durch Ätzen mit einem Ätzstopp an der Oxidschicht 14 durchgeführt werden. Die Breite des Loches bzw. des Öffnungsbereiches 32 beträgt beispielsweise 0,5 µm.

In einem Schritt 130 wird an der Seitenwand des Loches bzw. Öffnungsbereiches 32 ein Nitridseitenwandspacer gebildet, durch welchen in den darauffolgenden Schritten die Abscheidung von Si oder SiGe an der Seitenwand verhindert werden soll. Die Erzeugung des Abstandselements bzw. Spacers wird durch eine geeignete Technik, wie z.B. das TEOS-Verfahren, durchgeführt.

In einem Schritt 135 wird das Oxid der BOX-Schicht 14 an dem Öffnungsbereich 32 entfernt, um ein Fenster für den Basisbereich 26 zu bilden. Die Entfernung kann beispielsweise mittels Naßätzen oder eines anderen isotropen Ätzschrittes durchgeführt werden. Durch das Unterätzen der SOI-Schicht 16 wird erzielt, daß sich das Fenster für den Basisbereich 26 zwischen den Basisanschlußbereich 28 und das p-Substrat 12 erstreckt, so daß der im nachfolgenden Schritt in dem Fenster erzeugte Basisbereich 26 mit dem Basisanschlußbereich 28 in Kontakt gerät.

In einem Schritt 140 wird durch selektives epitaktisches Aufwachsen Si oder SiGe in dem Fenster für den Basisbereich 26 aufgebracht bzw. abgeschieden, wodurch der epitaktische Basisbereich 26 erzeugt wird. Die Basisdotierung wird vorzugsweise während der Epitaxie durchgeführt, wodurch das Dotierungsprofil steiler eingestellt werden kann.

In einem Schritt 145 wird die Nitridschicht (nicht gezeigt) entfernt, um bei einem darauffolgenden nächsten Schritt 150 den endgültigen Nitridseitenwandspacer 34 zu erzeugen, der das Emitterfenster 36 definiert, welcher beispielsweise lediglich eine Breite von 0,25 µm aufweist.

In einem Schritt 155 wird auf dem Basisbereich 26 in dem Emitterfenster 36 sowie auf der Oxidschicht 18 ein n-, wie z.B. Arsen-, dotiertes Polysilizium aufgebracht und strukturiert, um den Emitterbereich 38 zu bilden.

In einem Schritt 166 wird danach Oxid aufgebracht, um die Isolierschicht 20 zu bilden.

In einem Schritt 165 werden danach die Wolframkontaktierungen 40, 42, 44 hergestellt, indem Durchführungslöcher, die sich vertikal von der Außenoberfläche der Isolationsschicht 20 aus bis zu dem Basisanschluß- 28, Emitter- 38 und Kollektorbereich 24 erstrecken, erzeugt und anschließend mit einer Wolframfüllung versehen werden.

In einem Schritt 170 werden die Emitter-, Kollektor- und Basiskontakte 46, 48 und 50 strukturiert, die mit den Kontaktierungen 40- 44 verbunden sind.

Es wird darauf hingewiesen, daß die Reihenfolge der Herstellungsschritte von Fig. 2 verändert werden kann. Es können beispielsweise die Schritte 105 bis 120 miteinander vertauscht werden. In Bezug auf Schritt 110 wird darauf hingewiesen, daß derselbe auch fehlen kann, d.h. daß der Bipolar-Transistor 5 keine STI-Grabenbereiche 30 aufweisen muß, wie z.B. in dem Fall, daß der Bipolar-Transistor 5 nicht mit einem Standard-SOI-CMOS-Verfahren kombiniert werden soll, bzw. nicht in eine CMOS-Schaltung integriert werden soll.

In Bezug auf die Form des Basisanschlußbereiches 28 wird darauf hingewiesen, daß derselbe nicht ringförmig bzw. rahmenförmig gebildet sein muß. Notwendig ist lediglich, daß eine laterale Überlappung mit dem Basisbereich 26 existiert, um einen Kontakt zwischen denselben herzustellen. In Bezug auf die oben angegebenen verwendeten Materialien sowie Dotierungen, wie z.B. insbesondere der Kollektorwanne 25, des Basisbereiches 26, des Basisanschlußbereiches 28, des Emitterbereiches 38 und der Kontaktierungen 40, 42 und 44, wird darauf hingewiesen, daß dieselben variiert werden können. Insbesondere ist die vorhergehende Beschreibung auch auf pnp-Bipolar-Transistoren anwendbar, in welchem Fall sich die im vorhergehenden angegebenen Leitungstypen umkehren.

Der im vorhergehenden beschriebene Bipolar-Transistor weist im Vergleich zu dem in Fig. 3 gezeigten Bipolar-Transistor des herkömmlichen Typs den Vorteil auf, daß die Anzahl von Prozeßschritten bei der Herstellung reduziert ist, wodurch sich die Kosten des Bipolar-Transistors reduzieren. Zudem besteht der Emitteranschlußbereich 28 aus monokristallinem Silizium, wodurch wesentlich niedrigere externe Basiswiderstände realisiert und hierdurch die Anwendbarkeit für Low-Noise-Anwendungen verbessert wird.

Im Vergleich zu dem in der Beschreibungseinleitung erwähnten Heterostruktur-Bipolar-Transistor ergibt sich der Vorteil, daß die Basis eine epitaxiale Basis ist, daß die SOI-Schicht aufgrund der Tatsache, daß in derselben lediglich der Basisanschlußbereich und nicht der Kollektor gebildet ist, dünner sein kann, und daß zur Herstellung eine geringere Anzahl an Aufbringungs- und Aufwachsherstellungsschritte notwendig sind, da lediglich der Basisbereich 26 und der Emitterbereich 38 aufgebracht werden müssen, während der Basisanschlußbereich bereits durch die SOI-Schicht vorhanden ist.

### Bezugszeichenliste

- 5: Bipolar-Transistor
- 10: Schichtfolge
- 12: p-Substrat
- 14: BOX-Schicht
- 16: SOI-Schicht
- 18: zweite Oxidschicht
- 20: Isolationsschicht
- 22: Metallschicht
- 24: n-Kollektorwanne
- 26: Basisbereich
- 28: Basisanschlußbereich
- 30: STI-Grabenbereich
- 32: Öffnungsbereich
- 34: Spacer
- 36: Emitterfenster
- 38: Emitterbereich
- 40: Kontaktierung
- 42: Kontaktierung
- 44: Kontaktierung
- 46: Basiskontakt
- 48: Emitterkontakt
- 50: Kollektorkontakt
- 500: Bipolar-Transistor
- 502: p-Substrat
- 504: erste Oxidschicht
- 506: Polysiliziumschicht
- 508: zweite Oxidschicht
- 510: Isolationsschicht
- 518: Metallschicht
- 520a: STI-Grabenbereich
- 520b: STI-Grabenbereich
- 520c: STI-Grabenbereich
- 522: n-Kollektorwanne
- 524: Basisanschlußbereich
- 526: Loch
- 528: Spacer
- 530: Emitterfenster
- 532: Basisbereich
- 534: Emitterbereich
- 536: Kontaktierung
- 538: Kontaktierung
- 540: Kontaktierung
- 542: Basiskontakt
- 544: Emitterkontakt
- 546: Kollektorkontakt

## Patentansprüche

1. Verfahren zum Herstellen eines Bipolar-Transistors, mit folgenden Schritten:
(a) Bereitstellen (100) einer Schichtfolge (10), die ein Substrat (12), eine erste Oxidschicht (14) und eine monokristalline SOI-Schicht (16) umfaßt;
(b) Erzeugen (105) eines Kollektorbereichs (24) in dem Substrat (12);
(c) Erzeugen (115) einer zweiten Oxidschicht (18) auf der Schichtfolge (10) derart, daß die zweite Oxidschicht (18) auf der monokristallinen SOI-Schicht angeordnet ist;
(d) Erzeugen (125, 130, 135, 140) eines Basisbereichs in der ersten Oxidschicht (14), derart, daß der Basisbereich (26) mit der monokristallinen SOI-Schicht (16) in Kontakt ist;
(e) Erzeugen (150, 155) eines Emitterbereichs (38) auf dem Basisbereich (26), derart, daß der Emitterbereich (38) von der monokristallinen SOI-Schicht (16) isoliert ist; und
(f) Erzeugen (165, 170) eines Kollektorkontakts (50), eines Basiskontakts (46) und eines Emitterkontakts (48).

2. Verfahren gemäß Anspruch 1, bei dem der Schritt (b) eine Hochenergieimplantation aufweist, um als Kollektorbereich (24) eine Kollektorwanne (24) in dem Substrat (12) zu erzeugen.

3. Verfahren gemäß Anspruch 1 oder 2, das zwischen dem Schritt (b) und (c) folgenden Schritt aufweist:
Strukturieren (110) der monokristallinen SOI-Schicht (16), um einen Basisanschlußbereich (28) aus der monokristallinen SOI-Schicht (16) und einen Grabenbereich (16) zu erzeugen.

4. Verfahren gemäß Anspruch 3, das nach dem Schritt des Strukturierens folgenden Schritt aufweist:
Bilden (110) einer Grabenisolation (30) in dem Grabenbereich (30).

5. Verfahren gemäß einem der Ansprüche 1 bis 4, bei dem der Schritt (c) vor dem Schritt (b) durchgeführt wird.

6. Verfahren gemäß einem der Ansprüche 1 bis 5, bei dem der Schritt (d) ferner folgende Schritte aufweist:
(d1) Strukturieren (125) der zweiten Oxidschicht (18) und der monokristallinen SOI-Schicht (16), um einen Teil einer Oberfläche der ersten Oxidschicht (14) freizulegen, die dem Substrat (12) gegenüberliegt;
(d2) teilweises Entfernen (135) der ersten Oxidschicht (14), um ein Fenster zu erzeugen, das sich teilweise über den Teil der Oberfläche der ersten Oxidschicht (14), teilweise zwisehen die monokristalline SOI-Schicht (16) und das Substrat (12) und teilweise über den Kollektorbereich (24) erstreckt.
(d3) Bilden (140) des Basisbereichs (26) in dem Fenster.

7. Verfahren gemäß Anspruch 6, bei dem der Schritt (d2) ein Naßätzen (135) der ersten Oxidschicht (14) von dem freigelegten Teil der Oberfläche aus aufweist.

8. Verfahren gemäß Anspruch 6 oder 7, bei dem der Schritt (d3) ein epitaktisches Aufwachsen (140) in dem Fenster aufweist, um ein epitaktisches Basisgebiet (26) zu erzeugen.

9. Verfahren gemäß einem der Ansprüche 6 bis 8, bei dem der Schritt (d) ferner folgenden Schritt aufweist:
zwischen den Schritten (d1) und (d2), Bilden (130) eines isolierenden Abstandselements entlang einer Seitenwand der SOI-Schicht, die den freigelegten Teil der Oberfläche der ersten Oxidschicht (14) umgibt.

10. Verfahren gemäß einem der Ansprüche 1 bis 9, bei dem der Schritt (e) ferner folgenden Schritt aufweist:
(e1) Aufbringen von Polysilizium auf einem Teil des Basisbereichs (26).

11. Verfahren gemäß einem der Ansprüche 1 bis 10, bei dem der Schritt (e) ferner folgenden Schritt aufweist:
(e2) vor dem Schritt (e1), Bilden eines isolierenden Abstandselements (34) zwischen einem Rand des Teils des Basisbereichs (26) und einer Seitenwand der monokristallinen SOI-Schicht (16), die den Teil des Basisbereichs (26) umgibt.

12. Verfahren gemäß einem der Ansprüche 1 bis 11, bei dem der Schritt (f) ferner folgende Schritte aufweist:
(f1) Kontaktieren des Kollektorkontakts (50) mit dem Kollektorbereich (24);
(f2) Kontaktieren des Basiskontakts (46) mit der monokristallinen SOI-Schicht (16); und
(f3) Kontaktieren des Emitterkontakts (48) mit dem Emitterbereich (38).

13. Bipolar-Transistor mit
einer Schichtfolge (10), die ein Substrat (12), eine Oxidschicht (14) und eine monokristalline SOI-Schicht (16) umfaßt;
einem Kollektorbereich (24) in dem Substrat (12);
einer zweiten Oxidschicht (18) auf der Schichtfolge (10) derart, daß die zweite Oxidschicht (18) auf der monokristallinen SOI-Schicht angeordnet ist;
einem Basisbereich (26) in der ersten Oxidschicht (14), der mit der monokristallinen SOI-Schicht (16) in Kontakt ist;
einem Emitterbereich (38) auf dem Basisbereich (26), der von der monokristallinen SOI-Schicht (16) isoliert ist; und
einem Kollektorkontakt (50), einem Basiskontakt (46) und einem Emitterkontakt (42).

## Claims

1. Method for producing a bipolar transistor, comprising:
(a) providing (100) a layer sequence (10), which comprises a substrate (12), a first oxide layer (14) and a monocrystalline SOI layer (16);
(b) generating (105) a collector region (24) in the substrate (12);
(c) generating (115) a second oxide layer (18) on the layer sequence (10), such that the second oxide layer (18) is arranged on the monocrystalline SOI layer;
(d) generating (125, 130, 135, 140) a base region in the first oxide layer (14), such that the base region (26) is in contact with the monocrystalline SOI layer (16);
(e) generating (150, 155) an emitter region (38) on the base region (26), such that the emitter region (38) is isolated from the monocrystalline SOI layer (16); and
(f) generating (165, 170) a collector contact (50), a base contact (46) and an emitter contact (48).

2. Method according to claim 1, wherein step (b) comprises a high-energy implantation to generate a collector well (24) in the substrate (12) as collector region (24).

3. Method according to claim 1 or 2, which comprises the following step between step (b) and (c):
structuring (110) the monocrystalline SOI layer (16) to generate a base terminal region (28) from the monocrystalline SOI layer (16) and a trench region (16).

4. Method according to claim 3, which comprises the following step after the step of structuring:
forming (110) a trench isolation (30) in the trench region (30).

5. Method according to one of claims 1 to 4, wherein step (c) is performed prior to step (b).

6. Method according to one of claims 1 to 5, wherein the step (d) further comprises the following steps:
(d1) structuring (125) the second oxide layer (18) and the monocrystalline SOI layer (16) to expose part of a surface of the first oxide layer (14), which faces the substrate (12);
(d2) partly removing (135) the first oxide layer (14) to generate a window, which extends partly across the part of the surface of the first oxide layer (14), partly between the monocrystalline SOI layer (16) and the substrate (12) and partly across the collector region (24);
(d3) forming (140) the base region (26) in the window.

7. Method according to claim 6, wherein step (d2) comprises wet etching of (135) the first oxide layer (14) from the exposed part of the surface.

8. Method according to claim 6 or 7, wherein step (d3) comprises epitaxial growth (140) to generate an epitaxial base region (26).

9. Method according to one of claims 6 to 8, wherein step (d) further comprises the following step:
between steps (d1) and (d2), forming (130) an isolating spacing element along a sidewall of the SOI layer, which surrounds the exposed part of the surface of the first oxide layer (14).

10. Method according to one of claims 1 to 9, wherein step (e) further comprises the following step:
(e1) depositing polysilicon on a part of the base region (26).

11. Method according to one of claims 1 to 10, wherein step (e) further comprises the following step:
(e2) prior to step (e1), forming an isolating spacing element (34) between a margin of part of the base region (26) and the sidewall of the SOI layer (16), which surrounds the part of the base region (26).

12. Method according to one of claims 1 to 11, wherein step (f) further comprises the following steps:
(f1) contacting the collector contact (50) with the collector region (24);
(f2) contacting the base contact (46) with the monocrystalline SOI layer (16); and
(f3) contacting the emitter contact (48) with the emitter region (38).

13. Bipolar transistor, comprising
a layer sequence (10), which comprises a substrate (12), an oxide layer (14) and an SOI layer (16);
a collector region (24) in the substrate (12);
a second oxide layer (18) on the layer sequence (10), such that the second oxide layer (18) is arranged on the monocrystalline SOI layer;
a base region (26) in the first oxide layer (14), which is in contact with the SOI layer (16);
an emitter region (38) on the a base region (26), which is isolated from the SOI layer (16); and
a collector contact (50), a base contact (46) and an emitter contact (42).

## Revendications

1. Procédé de fabrication d'un transistor bipolaire, comprenant les stades suivants :
(a) mise à disposition (100) d'une succession (10) de couches, qui comprend un substrat (12), une première couche (14) d'oxyde et une couche (16) SOI monocristalline ;
(b) production (105) d'une zone (24) de collecteur dans le substrat (12) ;
(c) production (115) d'une deuxième couche (18) d'oxyde sur la succession (10) de couches, de façon à ce que la deuxième couche (18) d'oxyde soit disposée sur la couche SOI monocristalline ;
(d) production (125, 130, 135, 140) d'une zone de base dans la première couche (14) d'oxyde de manière à ce que la zone (26) de base soit en contact avec la couche (16) SOI monocristalline ;
(e) production (150, 155) d'une zone (38) d'émetteur sur la zone (26) de base, de façon à ce que la zone (38) d'émetteur soit isolée de la couche (16) SOI monocristalline ; et
(f) production (165, 170) d'un contact (50) de collecteur, d'un contact (46) de base et d'un contact (48) d'émetteur.

2. Procédé suivant la revendication 1, dans lequel le stade (b) comporte une implantation à haute énergie pour produire comme zone (24) de collecteur une cuvette (24) de collecteur dans le substrat (12).

3. Procédé suivant la revendication 1 ou 2, qui comprend le stade suivant entre le stade (b) et le stade (c) :
structuration (110) de la couche (16) SOI monocristalline pour produire une zone (28) de borne de base à partir de la couche (16) SOI monocristalline et une zone (16) de sillon.

4. Procédé suivant la revendication 3, qui comporte le stade suivant après le stade de la structuration :
formation (110) de l'isolement (30) de sillon dans la zone (30) de sillon.

5. Procédé suivant l'une des revendications 1 à 4, dans lequel on effectue le stade (c) avant le stade (b).

6. Procédé suivant l'une des revendications 1 à 5, dans lequel le stade (d) comprend, en outre, les stades suivants :
(d1) structuration (125) de la deuxième couche (18) d'oxyde et de la couche (16) SOI monocristalline pour mettre à nu une partie de la surface de la première couche (14) d'oxyde qui est opposée au substrat (12) ;
(d2) élimination (135) partielle de la première couche (14) d'oxyde pour produire une fenêtre qui s'étend partiellement sur la partie de la surface de la première couche (14) d'oxyde, partiellement entre la couche (16) SOI monocristalline et le substrat (12) et partiellement sur la zone (24) de collecteur ;
(d3) formation (140) de la zone (26) de base dans la fenêtre.

7. Procédé suivant la revendication 6, dans lequel le stade (d2) comporte une attaque (135) en voie humide de la première couche (14) d'oxyde depuis la partie mise à nu de la surface.

8. Procédé suivant la revendication 6 ou 7, dans lequel le stade (d3) comporte une croissance (140) par épitaxie dans la fenêtre pour produire une zone (26) de base par épitaxie.

9. Procédé suivant l'une des revendications 6 à 8, dans lequel le stade (d) comprend, en outre, le stade suivant :
formation (130) entre les stades (d1) et (d2) d'un élément d'espacement isolant le long d'une paroi latérale de la couche SOI, qui entoure la partie mise à nu de la surface de la première couche (14) d'oxyde.

10. Procédé suivant l'une des revendications 1 à 9, dans lequel le stade (e) comprend, en outre, le stade suivant :
(e1) dépôt de polysilicium sur une partie de la zone (26) de base.

11. Procédé suivant l'une des revendications 1 à 10, dans lequel le stade (e) comprend, en outre, le stade suivant :
(e2) avant le stade (e1), formation d'un élément (34) isolant d'espacement entre un bord de la partie de la zone (26) de base et une paroi latérale de la couche (16) SOI monocristalline qui entoure la partie de la zone (26) de base.

12. Procédé suivant l'une des revendications 1 à 11, dans lequel le stade (f) comprend, en outre, les stades suivants :
(f1) mise en contact du contact (50) de collecteur avec la zone (24) de collecteur ;
(f2) mise en contact du contact (46) de base avec la couche (16) SOI monocristalline ; et
(f3) mise en contact du contact (48) d'émetteur avec la zone (38) d'émetteur.

13. Transistor bipolaire comprenant
une succession (10) de couches, qui comprend un substrat (12), une couche (14) d'oxyde et une couche (16) SOI monocristalline ;
une zone (24) de collecteur dans le substrat (12) ;
une deuxième couche (18) d'oxyde sur la succession (10) de couches, de façon à ce que la deuxième couche (18) d'oxyde soit disposée sur la couche SOI monocristalline ;
une zone (26) de base dans la première couche (14) d'oxyde, qui est en contact avec la couche (16) SOI monocristalline ;
une zone (38) d'émetteur sur la zone (26) de base, qui est isolée de la couche (16) SOI monocristalline ; et
un contact (50) de collecteur, un contact (46) de base et un contact (42) d'émetteur.
